# EUROPEAN PATENT APPLICATION

(11) **EP 2 251 698 A1**
(43) Date of publication of application: **17.11.2010**
(21) Application number: 09718138.2
(22) Date of filing: 30.01.2009
(51) Int. Cl.: G01N 35/08, B81B 1/00, G01N 37/00

(54) **MICROCHIP AND METHOD OF MANUFACTURING SAME**

(30) Priority: 07.03.2008 JP 2008058389
(71) Applicant: Konica Minolta Opto, Inc., Hachioji-shi Tokyo 192-8505 (JP)
(72) Inventor: HIRAYAMA, Hiroshi, Hachioji-shi Tokyo 192-8505 (JP)
(74) Representative: Henkel, Feiler & Hänzel
(86) International application number: PCT/JP2009/051561
(87) International publication number: WO 2009/110270

(57) **Abstract**

Provided are a microchip enabling accurate analysis by preventing a resin film from being deflected into a flow path groove to eliminate the stagnation of a liquid sample and a method of manufacturing the microchip. This microchip includes a flow path that is formed by joining a resin film onto the groove-formed surface of a resin substrate. The deflection angle of the resin film in the sectional surface of the flow path in the width direction is made to be 0 to less than 30° at respective positions of the flow path

## Description

### TECHNICAL FIELD

The present invention relates to a microchip having a flow path and a method for manufacturing the same.

### BACKGROUND TECHNOLOGY

There has been practically used a device, called a microanalysis chip or µTAS (Micro Total Analysis Systems), which carries out a chemical reaction, separation, or analysis of a liquid sample such as a nucleic acid, protein, and blood, on a minute space, which is created in such a way that minute flow path grooves are formed on a silicon or glass substrate using the micromachining technology, and then, a flow path or a circuit is formed by joining a tabular seal member to the aforesaid substrate. The merit of such a microchip may be to realize a small, portable and inexpensive system, in which an amount of sample or reagent to be used or an amount of emission of waste liquid are reduced.

In addition, from a demand for a reduction in a manufacturing cost, it has also been studied that the microchip is manufactured using a resin substrate and sealing member for a microanalysis chip.

As a method for joining a resin substrate to a resin sealing member, there have been known methods such as a method for utilizing an adhesive, a method for joining them by melting a resin surface with a solvent, a method for utilizing an ultrasonic fusion-bonding, a method for utilizing a laser fusion-bonding, and a method for utilizing a thermal fusion-bonding. However, in case of forming a flow path by joining a tabular seal member, if a slight strain or warp was present on the shape of the substrate or the sealing member, it became difficult to form a uniform flow path, which tended to be a problem for the microanalysis chip in which a very high accuracy was required.

Then, there has been studied a microchip, in which a resin film is joined to a resin substrate in which minute flow path grooves are formed. The aforesaid microchip is manufactured with a resin substrate, in which flow path grooves, as well as through-holes (being a chemical reagent introduction and discharge hole) arranged at an end of the flow path groove are formed on the surface, and a resin film which is joined to the resin substrate.

The method for joining the resin substrate to the resin film includes, similarly to the case of the microanalysis chip comprising the above resin substrate and tabular seal member, a method for utilizing an adhesive, a method for joining them by melting a resin surface with a solvent, a method for utilizing an ultrasonic fusion-bonding, a method for utilizing a laser fusion-bonding, and a method for utilizing a thermal fusion-bonding using a tabular or roll pressure device. Among these methods, since the thermal fusion-bonding can be carried out with a low cost, the method for utilizing the thermal fusion-bonding is a suitable joining method for a mass-production.

As the microchip of such a type, having been proposed is a microchip, in which an acrylic resin film such as polymethyl methacrylate is thermally fusion-bonded to an acrylic resin substrate (for example, Patent Document 1).
Patent Document 1: Japanese Patent Application Publication 1: No. 2000-310613

### DISCLOSURE OF THE INVENTION

### ISSUES TO BE SOLEVED BY THE INVENTION

However, when a microchip was formed by thermally fusion-bonding a resin substrate to a resin film according to a content described in the above patent document, and the formed microchip was analyzed, a problem was found that a variation of the flow rate of chemical reagent arose, resulting in a difficulty of an accurate analysis. It was also found that, when detection was carried out with detection light, the detection light diverged, resulting in a weak detection peak, thereby another problem that an accurate analysis became difficult was caused.

As a result of a diligent examination on these factors, it was found that the major factor was that, when the resin film is thermally fusion-bonded to the resin substrate, the resin film is deflected into the flow path or the through-hole.

As a result of further examination, it was found that the cause for the resin film being joined in a deformed state was that, as the resin film softened by heat is pressurized, the resin film was pushed into a space of the flow path or the through-hole. However, for these problems, it was difficult to balance the sufficient joint strength and a solution of the above-described problem, even if conditions such as press pressure or temperature during thermal fusion-bonding were changed.

It is presumed that the variation in the flow rate due to deflection of the resin film is caused by decrease in the flow rate of the liquid sample, because, in a state of the resin film being deflected into the flow path groove, the minute flow path formed by the flow path groove and the resin film becomes narrower than a proper shape of a cross section (such as a rectangle or a trapezoid). Further, it is presumed that an acute angle composed of a deflected part of the resin film and the surface of a wall of the flow path groove partially delays the flow rate of the liquid sample, which also becomes a cause to generate variation of the flow rate of the liquid sample, In addition, regarding also the diversion of the detection light, it is presumed that the deformed resin film scatters the detection light, resulting in a weak detection peak, thereby an accurate analysis becomes difficult, which also becomes the above cause.

Variation in a volume of through-hole depending on the deflection of the resin film into the through-hole causes variation in height of liquid level of the liquid sample filled in the through-hole. Since the volume of through-hole is extremely large compared to the volume of the flow path groove, variation of the volume of through-hole greatly affects a flow direction or a flow rate of the liquid sample in the flow path, and as a result, there is generated a case where analysis of the liquid sample can not be carried out, depending on particular flow direction or flow rate of liquid sample. Therefore, a large variation in a volume of through-hole, namely low quantitative capability of liquid sample, causes a great problem in the analysis of liquid sample. Further, there was a problem that, when a water head difference was created between a liquid sample of a through-hole and a liquid sample of the other through-hole, which difference was caused by a variation in height of liquid level of the liquid sample filled in the through-holes, a flow of liquid sample caused by the water head difference was created, resulting in a problem of decrease in reproducibility in the analysis of liquid sample.

To solve the above problem, the purpose of the present invention is to provide a microchip and a method for manufacturing thereof, which reduces the variation in the flow rate of liquid sample and makes it possible to achieve an accurate analysis, and at the same time, can restrain decrease in a detection peak of detection light, by setting the deflection quantity of resin film in a specific range.

Furthermore, the purpose of the present invention is to provide a microchip and a method for manufacturing thereof, winch improves the quantitative capability and reproducibility.

### MEASURES TO SOLVE THE ISSUES

To solve the above issues, the invention described in Claim 1 is a microchip which is composed of a resin substrate on which a flow path groove is formed, and has a flow path formed by joining a resin film to the surface of the substrate on which the above flow path groove is formed,
wherein, at each position of the above flow path, the deflection angle of the above resin film in a cross section in the width direction of the above flow path is 0° or more and less than 30 °.

The invention described in Claim 2 is the microchip described in Claim 1, wherein the deflection angle of the above resin film is 0° or more and less than 10 °.

The invention described in Claim 3 is the microchip described in Claims 1 or 2, wherein at each position of the above flow path, the value of ratio of the deflection quantity of the above resin film at the sectional surface in the width direction of the above flow path to a depth of the above flow path is 0 or more and less than 0.1.

The invention described in Claim 4 is the microchip described in Claim 3, wherein the value of ratio of the deflection quantity of the above resin film to a depth of the above flow path groove is 0 or more and less than 0.05.

The invention described in Claim 5 is the microchip described in any one of Claims 1 to 4 in which a through-hole connected to the above flow path groove is further formed on the above resin substrate,
wherein the above resin film is disposed so as to cover the above through-hole, and
the value of ratio of the deflection quantity of the above resin film to a depth of the above through-hole at the sectional surface in the longitudinal direction through the maximum diameter of the above through-hole is 0 or more and less than 0.05.

The invention described in Claim 6 is the microchip described in Claim 5, wherein the value of the deflection quantity of the above resin film with respect to a depth of the above through-hole at the sectional surface in the longitudinal direction through the maximum diameter of the above through-hole is 0 or more and less than 0.01.

The invention described in Claim 7 is a method for manufacturing the microchip, wherein the method has a step of forming a flow path by joining, via the thermal fusion deposition, a resin film to the surface of a resin substrate on which a flow path groove is formed, and
a step in which the deflection angle of the above resin film in the width direction of the above flow path is made to be 0° or more and less than 30° at each position of the above flow path by conducting thermal annealing at a prescribed temperature of the above resin substrate and the above resin film, both of which were subjected to the above joining process.

The invention described in Claim 8 is a method for manufacturing the microchip described in Claim 7, wherein the through-hole connected to the above flow path groove is formed on the above resin substrate, and the above resin film is joined to the above resin substrate so as to cover the above through-hole, and the value of ratio of the deflection quantity of the above resin film to a depth of the above through-hole at the sectional surface in the longitudinal direction through the maximum diameter of the above through-hole is made to be 0 or more and less than 0.05 by the above thermal annealing step.

The invention described in Claim 9 is a method for manufacturing the microchip described in Claim 8, wherein, in the joining step of the resin film to the surface of the above resin substrate on which the above flow path groove was formed, the above resin film is supported by inserting a pin in such a way that the tip of the pin is located at a position of almost the same as the height of the edge of hole of the above through-hole.

### EFFECTS OF THE INVENTION

According to the invention described in Claims 1 and 2, since the acute angle made by the deflected section of the resin film in the flow path and the surface of the wall of the flow path groove becomes larger, the flow rate of the liquid sample is not partially decreased at the acute angle portion, whereby stagnation of the liquid sample is controlled, and as a result, the liquid sample can be accurately analyzed.

According to the invention described in Claims 3 and 4, the cross section of the flow path does not become small, as well as the suppression of variation of the cross section, whereby the decrease in flow rate is prevented, and as a result, it becomes possible to prevent decrease in reproducibility of detection.

According to the invention described in Claims 5 and 6, the variation of volume of the through-hole can be suppressed, resulting in the variation of height of the surface of a liquid filled in the through-hole, for example the liquid sample, being suppressed, and thereby it becomes possible to improve the quantitative capability of the liquid sample. Further, it becomes possible to stop generation of a water head difference between a liquid sample of a through-hole and a liquid sample of the other through-hole, thereby it becomes possible to prevent a flow of the liquid sample originated from the head difference,

According to the invention described in Claim 7, when the thermal annealing is carried out after the resin film is joined to the resin substrate, the resin film shrinks, thereby it becomes possible to suppress the deflection of the resin film at the flow path.

According to the invention described in Claim 8, when the thermal annealing is carried out after the resin film is joined to the resin substrate, the resin film shrinks, thereby it becomes possible to suppress the deflection of the resin film at the through-hole.

According to the invention described in Claim 9, since the pin supports the resin film deflecting toward the through-hole when the resin film is joined to the resin substrate, the deflection of the resin film at the through-hole can be decreased or eliminated.

### BRIEF DESCRIPTION OF THE DRAWINGS

Fig. 1 shows explanation drawings of the embodiment of this invention, Fig. 1 a is a plan of a microchip, and Figs. 1b and 1c are cross sections of a flow path groove of the microchip.
Fig. 2 is drawings explaining a deflection of a resin film at a flow path groove, and Figs. 2a and 2b are cross section at the flow path groove.
Fig. 3 is a cross section explaining a deflection of a resin film at a through-hole.
Fig. 4 is explanation drawings showing a flow rate distribution of DNA in a flow path groove in the electrophoresis.
Fig. 5 is an explanation drawing showing a method for manufacturing a microchip relating to another embodiment
Fig. 6 is a table showing conditions of examples and comparative examples.
Fig. 7 is a cross section of a press provided with a gas vent.

### DESCRIPTION OF ALPHANUMERIC DESIGNATIONS

- θ:: deflection angle
- t:: deflection quantity of a resin film at a flow path groove
- T:: defecation quantity of a resin film at a through-hole
- d:: depth of flow path groove
- D:: depth of through-hole
- 10:: resin substrate
- 11:: flow path groove
- 12:: joint surface
- 13:: bottom
- 14:: surface of wall
- 15:: through-hole
- 16:: edge of hole
- 20:: resin film
- 21:: undersurface
- 30:: pin
- 31:: tip of pin
- 33:: gas vent

### BEST MODE FOR CARRYING OUT THE INVENTION

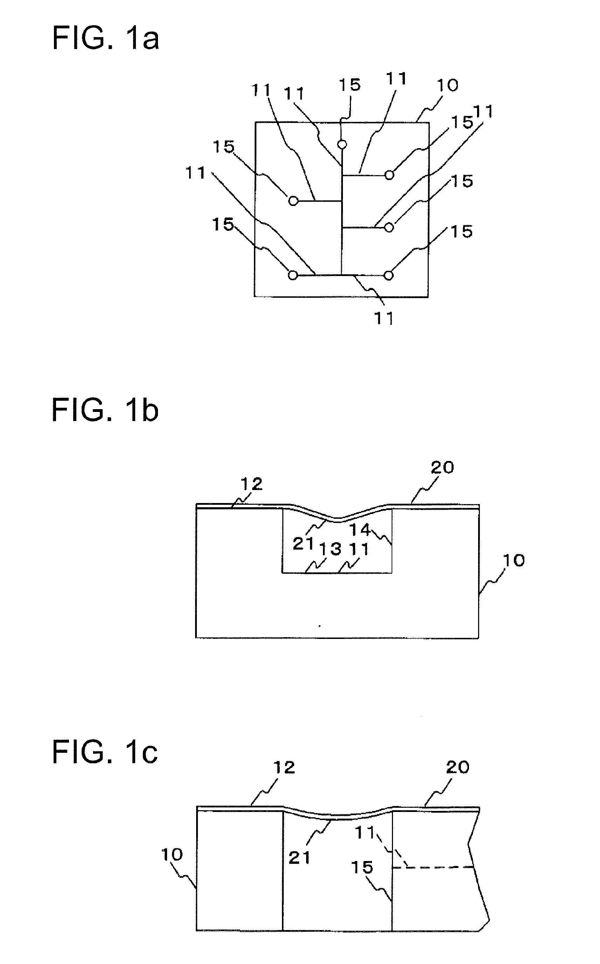

The microchip of the embodiment of this invention and its manufacturing method will be described with reference to Fig.1. Fig. 1 shows drawings explaining the microchip of the embodiment of this invention, Fig. 1a is a plan of the microchip, Fig. 1b is a cross section of a flow path of the microchip, and Fig. 1c is a cross section in the longitudinal direction at the maximum diameter of the through-hole of the microchip.

### (Constitution of Microchip)

As shown in Figs. 1a and 1b, the flow path groove 11 is formed on the surface of the resin substrate 10. The resin film 20 is joined to the joint surface 12 in which the flow path groove 11 of the resin substrate 10 is formed. The microchip is manufactured by joining the resin film 20 to the resin substrate 10. A minute flow path is constituted of the bottom 13 and surfaces of wall 14 of the flow path groove 11 and the undersurface 21 of the resin film 20.

As shown in Figs. 1a and 1c, a hole called the through-hole 15 is formed in order to inject a liquid sample (being an analysis sample, a solvent sample, or a reagent) into the minute flow path in the microchip. This hole is also referred to a well. In general, the minute flow path is formed in such a way that the through-hole 15 is formed at the end of or along the flow path groove 11 of resin substrate 10, and then, the resin film 20 is pasted to the joint surface 12 of the resin substrate 10. The liquid sample is introduced from the surface opposite to the joint surface 12 on which the resin film 20 was pasted.

The resin is used for the resin substrate 10 and the resin film 20. As the resin, there are listed as its conditions are properties such as excellent formability (being transferability, or releasability), high transparency, and low autofluorescence at UV light or visible light, but are not particularly limited to them. Preferable example includes polycarbonate, polymethyl methacrylate, polystyrene, polyacrylonitrile, polyvinyl chloride, polyethylene terephthalate, Nylon 6, Nylon 66, polyvinyl acetate, polyvinylidene chloride, polypropylene, polyisoprene, polyethylene, polydimethylsiloxane, and cyclic polyolefine, Particularly preferably are polymethyl methacrylate, and cyclic polyolefine. For the resin substrate 10 and the resin film 20, the same material may be used, or different materials may be used.

The size of the resin substrate 10 may be flexibly changed corresponding to purposes of analysis, or necessary functions, but the resin substrate 10 may be 5 mm square to 100 mm square. For example, in consideration of the manufacturing cost of the chip as well as the requirement that an analysis equipment with which a chip will be equipped be small, the size of the substrate is preferably 100 mm or less, and in consideration of the minimum need to integrate functions such as a well and a flow path into one chip as well as the handling ability of the chip, the size of the substrate is preferably 5 mm or more. The shape of the resin substrate 10 is generally a square or a rectangle, but the shape may be changed if necessary. For example, with the advantage that various shapes can readily be formed by the resin chip, projections for positioning or conveyance can be added, and further, the chip may be a round shape in case where a centrifugation function is made to be integrated into the chip.

The shape of the minute flow path is preferably within the range of 10 µm to 200 µm in both width and depth, in consideration that the amount of analysis sample or reagent to be used can be made small as well as manufacturing accuracy, transferability, or releasability of a forming die, but is not particularly limited to them. The aspect ratio (being a ratio of a depth of groove/a width of groove) is preferably about 0.1 to about 3, and more preferably about 0.2 to about 2. The width and the depth of the minute flow path may be determined according to the use of the microchip. Although the cross sectional shape of the minute flow path shown in Fig. 1 is a rectangle to make the explanation simple, the above shape is just one example of the minute flow path, and the shape may be a curved surface.

To prevent the resin film from being touched with or joined to the bottom of the flow path due to a slight deflection of the film during joining the film to the flow path, the lower limit of the aspect ratio was determined as described above. The upper limit of the aspect ratio was determined as described above in consideration of easy release of the flow path and maintaining the shape during injection molding or imprint molding of the flow path.

The board thickness of the resin substrate 10, on which minute flow paths were formed, is preferably about 0.2 mm to about 5 mm, and more preferably 0.5 mm to 2 mm in consideration of formability of the substrate. The board thickness of the resin film 20 (being a sheet-like member) functioning as a cover to cover the minute flow paths is preferably 30 µm to 300 µm, and more preferably 45 µm to 200 µm.

The lower limit of the film thickness is determined so as to maintain the minimum strength against external contact or damage, and the upper limit of the film thickness is determined by the followings: there is a case that thermal conductivity is required at the use of the chip, and there is a case that it is required that the quantity of optical noise of the film is small, as well as cost of materials, but the thickness is not limited to the above ranges. The proper film thickness may be determined depending on which elements described above are important.

Next, it will be described that, when the resin film 20 is joined to the joint surface 12 of the resin substrate on which the flow path groove 11 and the through-hole 15 are formed, the resin film 20 is deflected to the flow path groove 11 and to the through-hole 15.

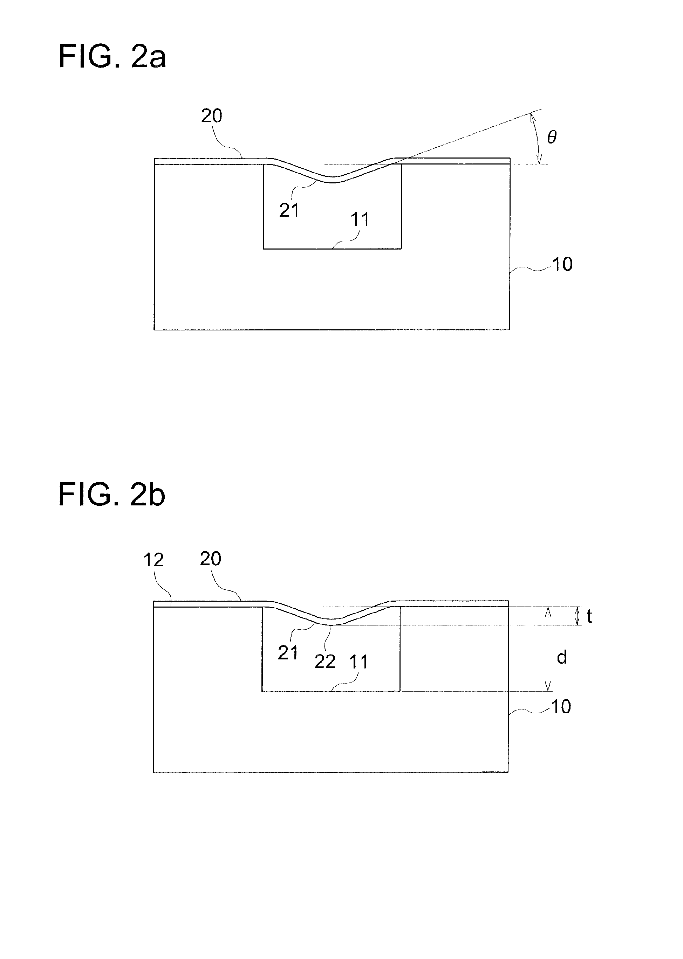

Next, there will be described the deflection angle θ and the deflection quantity t of the resin film 20 at the flow path with reference to Fig. 2. Fig. 2 is drawings explaining a deflection of the resin film at the flow path, and Figs. 2a and 2b are cross section at the flow path.

### (Deflection Angle)

First, the deflection angle of the resin film 20 will be described with reference to Fig. 2a. In the cross section in the width direction of the minute flow path, the maximum angle between a tangent line to the undersurface 21 of the resin film 20 which forms a side of the minute flow path and the joint surface 12 between the resin substrate 10 and the resin film 20 is defined as the deflection angle θ. If the surface of wall 14 of the flow path groove 11 of the resin substrate 10 is perpendicular to the joint surface 12, the available range of the deflection angle θ is 0 degree or more and 90 degrees or less (0≤ θ≤90°).

This deflection angle corresponds to the deflection angle θ of the resin film 20 at the cross section in the width direction at respective positions of the flow path.

Hereinafter, the deflection angle of the resin film 20 at the cross section in the width direction at respective positions of the flow path is simply referred to as a "deflection angle of a resin film at a flow path".

### (Deflection Quantity)

Next, the deflection quantity of the resin film 20 will be described with reference to Fig. 2b. In the cross section in the width direction of the minute flow path, the distance between any point of the undersurface 21 of the resin film 20 which forms a side of the minute flow path and the joint surface 12 between the resin substrate 10 and the resin film 20 is defined as a deflection quantity t. The distance described above is defined as, when a perpendicular line is drawn from the lowest point 22 of the undersurface 21 of the resin film 20 to a plane including the joint surface 12, the length of the perpendicular from the lowest point 22 to the plane.

This deflection quantity corresponds to the deflection quantity of the resin film 20 at the cross section in the width direction at respective positions of the flow path. Hereinafter, the deflection quantity of the resin film at respective positions in the width direction of the flow path groove is simply referred to as a "deflection quantity of a resin film at a flow path groove".

The deflection angle θ and the deflection quantity t of the resin film 20 at the flow path are preferably values described below from a viewpoint of a detection and flow of liquid reagent.

The deflection angle θ of the resin film 20 at the flow path is preferably 0 degree or more and less than 30 degrees, and more preferably 0 degree or more and less than 10 degrees. The deflection quantity t of the resin film 20 at the flow path is, with respect to the depth d of the flow path groove 11, preferably 0 or more and less than 0.1, and more preferably 0 or more and less than 0.05.

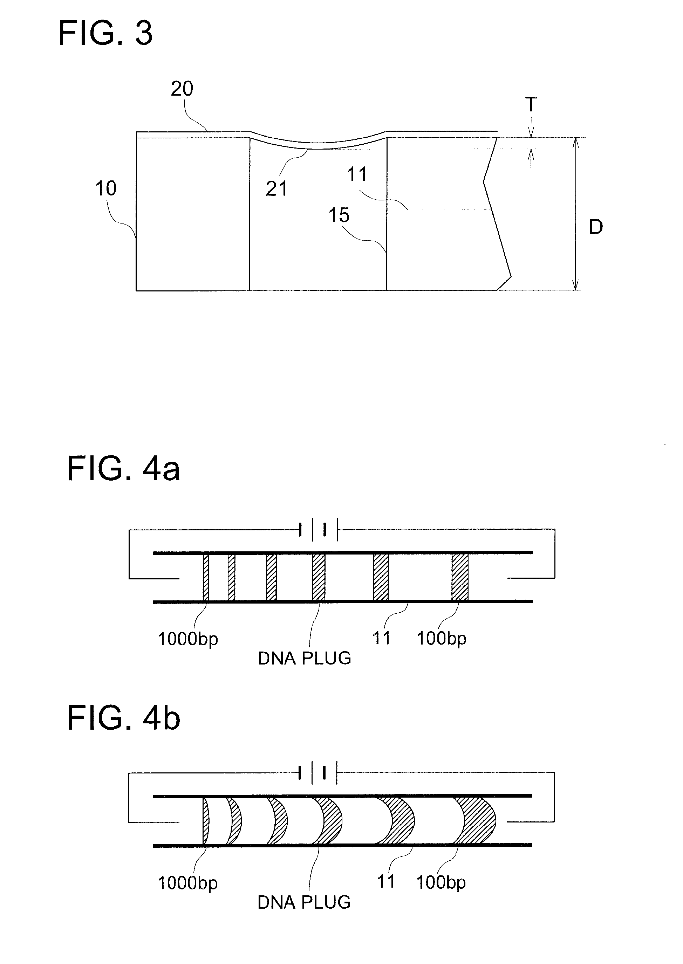

Next, the deflection quantity T of the resin film 20 at the through-hole 15 will be described with reference to Fig. 3. Fig. 3 is a cross section explaining a deflection of a resin film at a through-hole.

Regarding the resin film 20 covering the through-hole 15, in the cross section in the longitudinal direction through the maximum diameter of the through-hole 15, the distance to the joint surface 12 between the resin substrate 10 and the resin film 20 is defined as the deflection quantity T.

The deflection quantity T corresponds to a deflection quantity of the above resin film in the cross section in the longitudinal direction through the maximum diameter of the through-hole. The deflection quantity T of the above resin film in the cross section in the longitudinal direction through the maximum diameter of the through-hole is simply referred to as a "deflection quantity of a resin film at a through-hole".

The deflection quantity T of the resin film 20 at the through-hole 15 is preferably a value described below from a viewpoint of the quantitative capability of liquid reagent.

The deflection quantity T of the resin film 20 at the through-hole is, with respect to the depth D of the flow path groove 11, preferably 0 or more and less than 0.05, and more preferably 0 or more and less than 0.01.

Next, the determination methods of the deflection angle and deflection quantity of the resin film 20 will be described with reference to Figs. 2 and 3.

### (Determination Method of Deflection Angle)

First, the determination method of the deflection angle will be described. The confocal laser scanning microscope OLS3000, manufactured by Olympus Corporation, was used for the determination of the deflection angle. High precision determination can be performed by means of a laser light source of λ = 408 nm, a confocal optical system, and a precise scanning mechanism.

In case of determining the deflection angle of the undersurface 21 of the resin film 20 forming a part of the minute flow path, a three-dimensional shape of the undersurface 21 of the resin film 20 was determined by irradiating a laser beam from the upper surface of the resin film, and then, scanning the laser focal points from the undersurface 21 of the resin film 20 to the joint surface 12 of the resin film 20. And then, from the three-dimensional shape, the deflection angles at the cross section at respective positions were determined.

### (Determination Method of Deflection Quantity)

Next, the determination method of the deflection quantity will be described. The confocal laser scanning microscope OLS3000, manufactured by Olympus Corporation, was used for the determination of the deflection quantity. High precision determination can be performed by means of a laser light source of λ = 408 nm, a confocal optical system, and a precise scanning mechanism.

In case of determining the deflection quantity of the undersurface 21 of the resin film 20 forming a part of the minute flow path, a three-dimensional shape of the undersurface 21 of the resin film 20 was determined by irradiating a laser beam from the upper surface of the resin film, and then, scanning the laser focal points from the undersurface 21 of the resin film 20 to the joint surface 12 of the resin film 20. And then, from the three-dimensional shape, the deflection quantities at the cross section at respective positions were determined.

Next, regarding the detection of the liquid sample, the reason why the deflection angle θ at the flow path is 0 degree or more and less than 30 degrees (0≤θ < 30 °) will be described with reference to Fig. 2a.

At a detection portion of a minute flow path of a microchip, an analyzing object is detected. The major detection method includes a laser fluorescence detection system and a thermal lens detection system.

In the laser fluorescence detection system, laser is irradiated to the analyzing object to excite it, and then, fluorescence emitted from the analyzing object is detected by a photomultiplier or a CCD camera. When the analyzing object is set to be fluoreseently-labeled in advance, it is possible to selectively detect the analyzing object in a liquid sample.

In case of utilizing the laser fluorescence detection system, the laser light having a spot of almost same size as the width of the flow path of several tens microns is irradiated. In case where the resin film 20 has no deflection, that is, θ = 0, since the laser light perpendicularly enters the boundary layer between air and solvent, the laser light proceeds without being refracted to excite the analyzing object, thereby it is possible to detect emitted fluorescence by a photomultiplier or a CCD camera. However, in case where the resin film 20 has any deflection, since a solvent forms a pseudo concavo-plane cylindrical lens along the deflection of the resin film 20, the laser light diverges. As a result, reproducibility caused by a decrease in an amount of detection light and a variation of deflection angle of the resin film 20 decreases, and thereby an accurate detection can not be carried out.

On the other hand, in the thermal lens detection system, temperature of solvent around the analyzing object is raised by irradiating laser light onto the analyzing object to generate heat. As a result, a refractive index of the solvent locally changes, resulting in a change of the irradiated laser light path, and thereby the analyzing object can be detected by measuring the amount of the change. Since only a minute quantity of absorption of laser light is enough for the detection, the detection can be carried out for almost all substances. Though substances other than the analyzing object are also mistakenly detected, it is possible to separate the analyzing object from the other substances by separating them in advance at a flow path, and by the magnitude of the amount of change.

In case of utilizing the thermal lens detection system, a focus is formed in the solvent in the flow path by applying an optical systems of a microscope. In case where the resin film 20 has no deflection, the light obliquely entering the surface of the resin film 20 is refracted by the difference in the refractive index between air and solvent. However, since the amount of refraction is always fixed, it is possible to form a focus at any location in the solvent. However, in case where the resin film 20 has any deflection, since a solvent forms a pseudo concavo-plane cylindrical lens along the deflection of the resin film 20, the laser light diverges. Enlargement of the focal image is unavoidable, even if the amount due to the deflection of the resin film 20 is taken off, resulting in a decrease in detection sensitivity. If there exists variation in deflection angle at the flow path, a change of laser light path caused by generation of heat of the analyzing object can not be separated from a change of laser light path caused by variation in deflection angle, and therefore it becomes impossible to detect the analyzing object.

It was found that, in either one of the above two detection systems, if the deflection angle at the flow path exceeds a specific amount, the detection accuracy decreases or the detection becomes impossible. Although the permissible amount of the deflection angle depends on a configuration method of detection system, or a solvent or analysis sample, it was found as a result of experiments conducted by inventors that, if the deflection angle at the flow path is smaller than 30°, the above systems are usable by devising an appropriate detection method. Moreover, it was found that, if the deflection angle is smaller than 10°, the detection can be carried out more accurately.

Next, regarding the flow of the liquid sample, the reason why the deflection angle θ at the flow path is 0 degree or more and less than 30 degrees (0 ≤ θ < 30 °) will be described with reference to Fig. 4. Fig. 4 is explanation drawings showing a flow rate distribution of DNA in a flow path groove in the electrophoresis.

It is necessary to pour an analyzing object into a minute flow path in a microchip by controlling a flow rate using a voltage driving or a pressure driving. It was found that, in doing so, a shape of a minute flow path affects a flow rate distribution in a flow path.

In case of using either one of voltage driving or pressure driving, it is possible to separate the analyzing object by the charge amount or the molecular weight. Taking electrophoresis of DNA as an example, in case where DNA having the number of base pair of 100 bp to 1,000 bp is separated by applying a direct voltage in a flow path in which a viscous polymer solution is filled, the less the number of base pair of DNA, the faster the electrophoretic velocity of DNA, and the more the number of base pair of DNA, the slower the electrophoretic velocity of DNA, and as a result the DNA is separated as shown in Fig. 4a. The shape of cross section of the minute flow path is generally rectangular, or rectangular-like trapezoid because the side walls are slightly tapered during formation of the minute flow path. The plug (the band) of the DNA forms a plug flow, in which the flow rate distribution in the flow path is almost uniform. Therefore, since the boundary of the plug of the DNA is clear, the detection side can detects well-defined peaks.

On the other hand, if the resin film 20 has any deflection, in the shape of the cross section of the minute flow path, as shown in Fig. 1b, the angle between the resin film 20 and the surface of wall 14 of the flow path groove 11 becomes smaller than 90 °. According to the definition of the present invention, in case where the surface of wall 14 is perpendicular to the joint surface 12, the angle becomes (90 - θ)°. When the electrophoresis of the DNA is similarly carried out, the flow rate of the portion formed by the resin film 20 and the surface of wall 14 of the flow path groove 11 decreases. As a result, it was found that the plug shape of the DNA is deformed into a crescent shape as shown in Fig. 4b, thereby, even if it is possible to detect peaks at the detection side, the plug shape becomes a shape in which the peaks overlap with each other, resulting in a degradation in resolution of the detection.

As a result of carrying out the electrophoresis with DNA or protein, it was found that if the deflection angle at the flow path groove 11 exceeds a certain amount, the detection accuracy decreases or the detection becomes impossible. Although the permissible amount of the deflection angle depends on a configuration method of detection system, or a solvent or analysis sample, it was found as a result of experiments conducted by inventors that, if the deflection angle at the flow path is smaller than 30°, the above systems are usable by devising an appropriate detection method. Moreover, it was found that, if the deflection angle is smaller than 10 °, the detection can be carried out more accurately.

Next, the reason why a relationship between the deflection quantity t at the flow path and the depth d of the flow path groove 11 is preferably 0 ≤ t/d < 0.1 will be described with reference to Fig. 2b.

It is necessary to pour an analyzing object in a minute flow path in a microchip by controlling a flow rate using a voltage driving or a pressure driving. It was found as a result of an experiment that, in doing so, the cross section of the minute flow path affects a flow rate in the flow path. In particular, in case of the pressure driving, the smaller the cross section of the minute flow path, the lower the flow rate. There is no problem as long as the section has always the same shape, but, in case where the deflection amount varies among microchips, the flow rate also varies, resulting in a decrease in reproducibility. It was found as a result of an experiment conducted by inventors that if the relationship between the deflection quantity t and the depth d of the flow path groove 11 is 0 ≤ t/d < 0.1, the reproducibility of the detection is further increased. It was found that, in particular, if the relationship between the deflection quantity t and the depth d of the flow path groove 11 is 0 ≤ t/d < 0.05, the reproducibility is furthermore increased.

Next, the reason why a relationship between the deflection quantity T at the through-hole and the depth D of the through-hole is preferably 0 ≤ T/D < 0.05 will be described with reference to Fig. 3.

A hole, called the through-hole 15, is formed in order to inject a liquid sample (being an analysis sample, a solvent sample, or a reagent) into the minute flow path in the microchip. In general, the microchip is formed in such a way that the through-hole 15 is formed at the end of or along the flow path groove 11 of resin substrate 10, and the resin film 20 is pasted to the joint surface 12 of the resin substrate 10. The liquid sample is introduced from the surface opposite to the joint surface 12 to which the resin film 20 was pasted. In a chemical analysis or a biochemical analysis using a microchip, quantitative capability is usually required. The through-hole 15 has several hundreds microns to several millimeters in diameter and depth, while the minute flow path of the microchip generally has several tens microns to several hundreds microns in width and depth, therefore the most of the sample volume introduced remains in the through-hole 15. Therefore, in case where liquid sample is filled in the through-hole, if the shape of the through-hole 15 varies, the volume varies, resulting in cases where a problem may be caused in the qualitative capability. Further, in case where a constant amount of liquid sample is introduced into plural through-holes 15, a water head difference is created, and as a result, the liquid sample flows through the minute flow path in the direction of eliminating the water head difference, thereby a correct analysis can not possibly be carried out (the liquid flows due to the water head difference before the liquid is controlled using a voltage driving or a pressure driving.). It was found as a result of an experiment conducted by inventors that, if the relationship between the deflection quantity t and the depth D of the through-hole 15 is 0 ≤ t/D < 0.05, a further correct analysis can be achieved. It was found that, in particular, if the relationship between the deflection quantity t and the depth D of the through-hole 15 is 0 ≤ t/D < 0.01, the reproducibility of the analysis is further increased.

### (Thermal Annealing)

Next, the thermal annealing will be described. It can be assumed that generation of deflection of the resin film 20 at the flow path or through-hole 15 is a result that the resin film 20 covering the flow path groove 11 or the through-hole 15 is expanded, or the thickness of the resin film 20 is decreased due to pressurization, and as a result an increased area was push into the flow path groove 11 or the through-hole 15. Namely, in order to reduce the deflection of the resin film 20, or to eliminate the deflection of the resin film 20, the resin film 20 covering the flow path groove 11 or the through-hole 15 may be contracted. It was ensured by an experiment that heating to about a glass transition temperature contracts the resin film, and as a result, the deflection of the resin film 20 is reduced or eliminated. Since the thermal annealing conditions such as heating temperature and heating time vary with physical properties and the thickness of the resin film 20, a width of the flow path groove 11, and a diameter of the through-hole 15, the above conditions are required to be determined for each microchip. The thermal annealing condition is equivalent to the prescribed temperature condition.

The heating method includes a method for putting the microchip into a thermal environment using a thermostat oven; a method for partially heating the surface of the microchip by using a heat air blower; and a method for heating the resin film 20 by making the resin film 20 absorb ultraviolet light by using an ultraviolet light irradiation device, but is not limited to them. The longer heating time was effective for the correction of the deflection, but since it possibly causes deterioration of the resin, deformation of the minute flow path, or deformation of the resin substrate itself, it is necessary to regulate conditions so as not to cause these degradation or deformation.

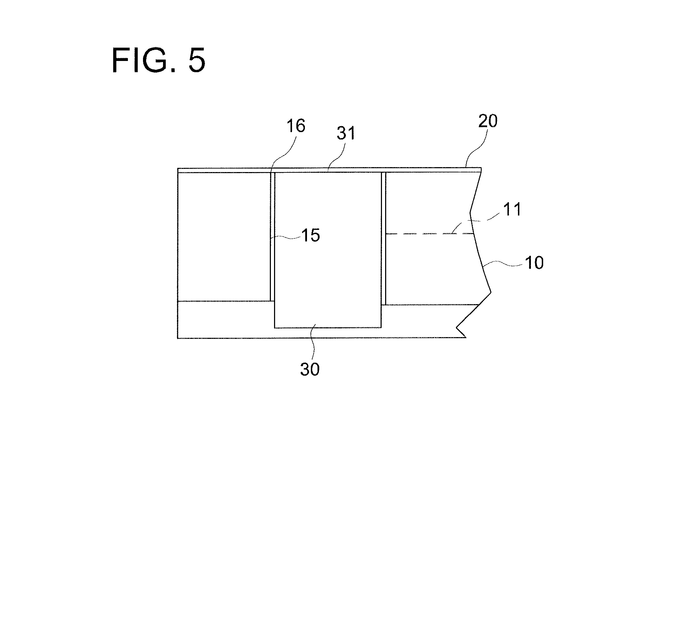

The method for manufacturing the microchip is not limited to the manufacturing method of the above embodiment. For example, as shown in Fig. 5, it may be constituted in such a way that, when the resin film 20 is joined to the resin substrate 10, the pin 30 is in advance inserted into the through-hole 15 and by placing the tip 31 of the pin 30 at a position of almost the same as the height of the edge ofhole 16 of the above through-hole 15, to support the resin film 20. Shown in Fig. 5 is a pin 30 in which the tip 31 of the pin 30 was inserted into the position of the edge of hole 16 of the through-hole 15.

The quality of the material of the pin may be an insulating member such as ceramic, rubber and resin, which can prevent the film from the thermal expansion. The surface of the pin may be subjected to a treatment using OPTOOL, manufactured by Daikin Industries, Ltd. or TEFLON (registered trademark), manufactured by DuPont, which can prevent the film from sticking to the tip of the pin.

According to the above constitution, when the resin film 20 is joined to the resin substrate 10, the pin 30 supports the resin film 20, which prevents the resin film 20 from being deflected into the through-hole 15. By doing so, the deflection of the resin film 20 into the through-hole 15 is reduced. The thermal annealing, after the resin film 20 having been joined, further reduces the deflection of the resin film 20 into the through-hole 15, or eliminates the deflection of the resin film 20.

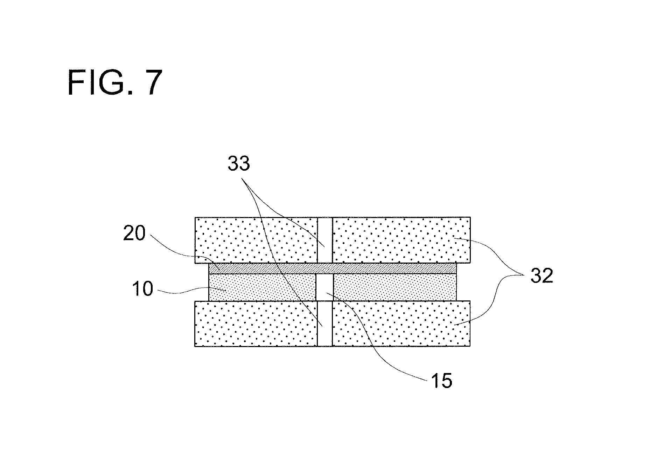

Further, as shown in Fig. 7, the gas vents 33, as a gas venting hole, may be arranged at a heat press plate 32 located at undersurface of the through-hole and at a heat press plate located on the upper surface of the film placed on the through-hole. According to the constitution, when the resin film 20 is joined to the resin substrate 10, the resin film 20 placed on the through-hole 15 is not subjected to a direct heating and pressure, and further the resin film 20 is not subjected to an extra physical stress at a time of being released from the heat press plate 32, and thereby the resin film 20 can be prevented from being deflected into the through-hole 15. By doing so, the deflection of the resin film 20 into the through-hole 15 is reduced. The thermal annealing, after the resin film 20 having been joined, further reduces the deflection of the resin film 20 into the through-hole 15, or eliminates the deflection of the resin film 20.

### EXAMPLES

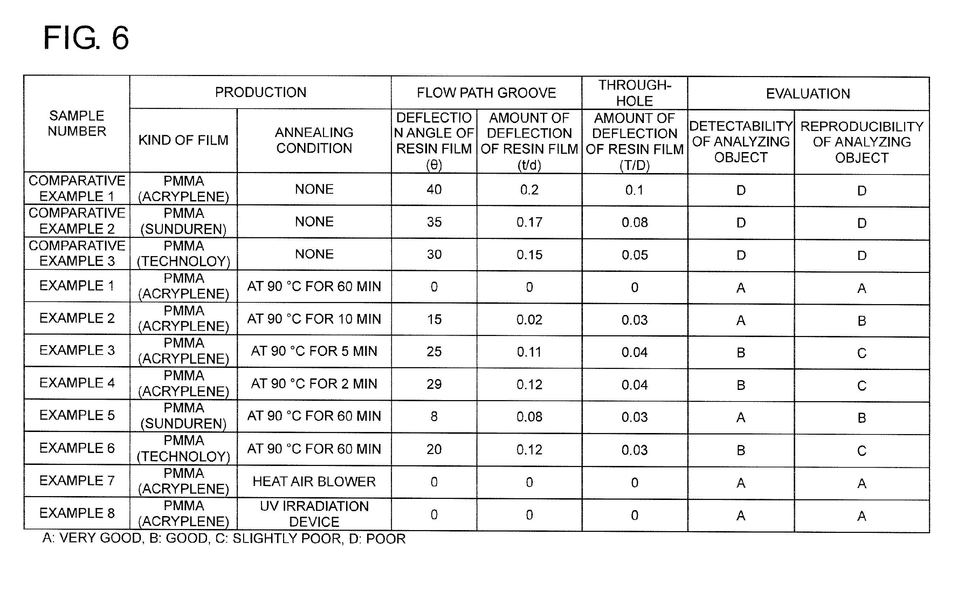

Next, specific examples and comparative examples will be described with reference to Figs. 2, 3 and 6. Fig. 6 is a table showing conditions of examples and comparative examples.

Each of the examples will be described below. Each of the examples is an example of a case where a microchip is subjected to thermal annealing after the resin substrate 10 and the resin film 20 are joined with each other.

### (Example 1)

### (Joining of Resin Substrate 10 to Resin Film 20, and Thermal Annealing)

Next, Example 1 will be described. An acrylic resin such as polymethyl methacrylate, which is a transparent resin material, (DELPET 70 NH, manufactured by Asahi Kasei Corp.) was molded using an injection molding machine to manufacture the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin film 20, an acrylic resin such as polymethyl methacrylate, which is a transparent resin materials, (ACRYPLENE, 75 µm in thickness, manufactured by Mitsubishi Rayon Co., Ltd.), was cut into 50 mm × 50 mm. Then, the resin film 20 was placed on the joint surface 12 of the resin substrate 10 on which the flow path grooves 11 were formed, which were then pressure bonded using a heat press at press temperature of 90 °C and with a force of 10 kgf/cm² to join the resin substrate 10 to the resin film 20. After joining them, using the confocal laser scanning microscope OLS3000, manufactured by Olympus Corporation, the deflection angle and the amount of deflection of the resin film 20 at the flow path groove 11 and the amount of deflection of the resin film 20 at the through-hole 15 were determined. The results were as follows: the deflection angle θ of the resin film 20 was 40 °, the ratio of the amount of the deflection t with respect to the depth d of the flow path groove 11 (= t/d) was 0.2, and the ratio of the amount of the deflection T with respect to the depth D of the through-hole 15 (= T/D) was 0.1. Subsequently, the joined microchip 20 was put into a thermostat oven at 90 °C for one hour. After the above treatment, the deflection angle and the amount of deflection of the resin film 20 at the flow path groove 11 and the amount of deflection of the resin film 20 at the through-hole 15 were re-determined, and the results were as follows: the deflection angle θ = 0 °, t/d = 0, and T/D = 0, thereby it was confirmed that the deflection was entirely eliminated.

### (Test of Electrophoresis using Microchip)

First, a viscous polymer solution (polydimethylacrylamide, pDMA) was charged from the through-hole 15. Since the resin substrate 10 made of acrylic resin such as polymethyl methacrylate is hydrophilic, it was possible to introduce it through capillarity. The polymer solution was also charged into each of through-holes 15 so as to level the liquid. After that, a fluorescently-labeled DNA having the number of base pair of 100 bp to 1,000 bp was dropped into the through-hole 15 for injecting a sample, and then, introduction and separation were carried out by applying a direct voltage. When excitation and detection were carried out at a prescribed detection section by using a confocal laser scanning microscope, it was observed that the DNA plug (a band) was separated while forming a plug flow. Since the boundaries of the DNA plugs were clear, clear peaks were detected at a detection side. When multiple tests were conducted on a like-for-like basis, very good reproducibility was confirmed.

### (Example 2)

### (Joining of Resin Substrate 10 to Resin Film 20, and Thermal Annealing)

Next, Example 2 will be described. An acrylic resin such as polymethyl methacrylate, which is a transparent resin material, (DELPET 70 NH, manufactured by Asahi Kasei Corp.) was molded using an injection molding machine to manufactured the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin film 20, an acrylic resin such as polymethyl methacrylate, which is a transparent resin material, (ACRYPLENE, 75 µm in thickness, manufactured by Mitsubishi Rayon Co., Ltd.), was cut into 50 mm × 50 mm. Then, the resin film 20 was placed on the joint surface 12 of the resin substrate 10 on which the flow path grooves 11 were formed, which were then pressure bonded using a heat press at press temperature of 90 °C and with a force of 10 kgf/cm² to join the resin substrate 10 to the resin film 20. After joining them, using the confocal laser scanning microscope OLS3000, manufactured by Olympus Corporation, the deflection angle and the amount of deflection of the resin film 20 at the flow path groove 11 and the amount of deflection at the through-hole 15 were determined. The results were as follows: the deflection angle θ of the resin film 20 was 40 °, the ratio of the amount of the deflection t with respect to the depth d of the flow path groove 11 (= t/d) was 0.2, and the ratio of the amount of the deflection T with respect to the depth D of the through-hole 15 (= T/D) was 0.1. Subsequently, the joined microchip 20 was put into a thermostat oven at 90 °C for 10 minutes. After the above treatment, the deflection angle and the amount of deflection of the resin film 20 at the flow path groove 11 and the amount of deflection of the resin film 20 at the through-hole 15 were re-determined, and the results were as follows: the deflection angle θ =15°, t/d = 0.02, and T/D = 0.03, thereby it was confirmed that the deflection of the resin film 20 was reduced.

### (Test of Electrophoresis using Microchip)

First, a viscous polymer solution (polydimethylacrylamide, pDMA) was charged from the through-hole 15. Since the resin substrate 10 made of acrylic resin such as polymethyl methacrylate is hydrophilic, it was possible to introduce it through capillarity. The polymer solution was also charged into each of through-holes 15 so as to level the liquid. After that, a fluorescently-labeled DNA having the number of base pair of 100 bp to 1,000 bp was dropped into the through-hole 15 for injecting a sample, and then, introduction and separation were carried out by applying a direct voltage. When excitation and detection were carried out at a prescribed detection section by using a confocal laser scanning microscope, the central portion of the DNA plug (a band) showed a shape similar to a plug flow, even though a slight tailing of the DNA plug at the both ends of the flow path groove 11 was observed. Since the boundaries of the DNA plugs were clear, clear peaks were detected at a detection side. When multiple tests were conducted on a like-for-like basis, good reproducibility was confirmed.

### (Example 3)

### (Joining of Resin Substrate 10 to Resin Fihn 20, and Thermal Annealing)

Next, Example 3 will be described. An acrylic resin such as polymethyl methacrylate, which is a transparent resin material, (DELPET 70 NH, manufactured by Asahi Kasei Corp.) was molded using an injection molding machine to manufacture the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin fihn 20, an acrylic resin such as polymethyl methacrylate, which is a transparent resin material, (ACRYPLENE, 75 µm in thickness, manufactured by Mitsubishi Rayon Co., Ltd.), was cut into 50 mm × 50 mm. Then, the resin film 20 was placed on the joint surface 12 of the resin substrate 10 on which the flow path grooves 11 were formed, which were then pressure bonded using a heat press at press temperature of 90 °C and with a force of 10 kgf/cm², to join the resin substrate 10 to the resin film 20. After joining them, using the confocal laser scanning microscope OLS3000 manufactured by Olympus Corporation, the deflection angle and the amount of deflection of the resin film 20 at the flow path groove 11 and the amount of deflection of the resin film 20 at the through-hole 15 were determined. The results were as follows: the deflection angle θ of the resin film 20 was 40 °, the ratio of the amount of the deflection t with respect to the depth d of the flow path groove 11 (=t/d) was 0.2, and the ratio of the amount of the deflection T with respect to the depth D of the through-hole 15 (=T/D) was 0.1. Subsequently, the joined microchip 20 was put into a thermostat oven at 90 °C for 5 minutes. After the above treatment, the deflection angle and the amount of deflection of the resin film 20 at the flow path groove 11 and the amount of deflection of the resin film 20 at the through-hole 15 were re-determined, and the results were as follows: the deflection angle θ = 25 °, t/d = 0.11, and T/D =0.04, thereby it was confirmed that the deflection of the resin film 20 was reduced.

### (Test of Electrophoresis using Microchip)

First, a viscous polymer solution (polydimethylacrylamide, pDMA) was charged from the through-hole 15. Since the resin substrate 10 made of acrylic resin such as polymethyl methacrylate is hydrophilic, it was possible to introduce it through capillarity. The polymer solution was also charged into each of through-holes 15 so as to level the liquid. After that, a fluorescently-labeled DNA having the number of base pair of 100 bp to 1,000 bp was dropped into the through-hole 15 for injecting a sample, and then, introduction and separation were carried out by applying a direct voltage. When excitation and detection were carried out at a prescribed detection section by using a confocal laser scanning microscope, the central portion of the DNA plug (band) showed a shape similar to a plug flow, even though a slight tailing of the DNA plug at the both ends of the flow path groove 11 was observed. Since the boundaries of the DNA plugs were clear, clear peaks were detected at a detection side. When multiple tests were conducted on a like-for-like basis, due to an effect of the resin film 20 being deflected toward the inside of the flow path groove 11, the cross section of the minute flow path was unstable, resulting in slight degradation of the reproducibility. However, it was found that the microchip was a usable level depending on the particular analyzing object.

### (Example 4)

### (Joining of Resin Substrate 10 to Resin Film 20, and Thermal Annealing)

Next, Example 4 will be described. An acrylic resin such as polymethyl methacrylate, which is a transparent resin material, (DELPET 70 NH, manufactured by Asahi Kasei Corp.) was molded using an injection molding machine to manufacture the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin film 20, an acrylic resin such as polymethyl methacrylate, which is a transparent resin material, (ACRYPLENE, 75 µm in thickness, manufactured by Mitsubishi Rayon Co., Ltd.), was cut into 50 mm × 50 mm. Then, the resin film 20 was placed on the joint surface 12 of the resin substrate 10 on which the flow path grooves 11 were formed, which were then pressure bonded using a heat press at press temperature of 90 °C and with a force of 10 kgf/cm², to join the resin substrate 10 to the resin film 20. After joining them, using the confocal laser scanning microscope OLS3000 manufactured by Olympus Corporation, the deflection angle and the amount of deflection of the resin fihn 20 at the flow path groove 11 and the amount of deflection of the resin film 20 at the through-hole 15 were determined. The results were as follows: the deflection angle θ of the resin film 20 was 40 °, the ratio of the amount of the deflection t with respect to the depth d of the flow path groove 11 (=t/d) was 0.2, and the ratio of the amount of the deflection T with respect to the depth D of the through-hole 15 (= T/D) was 0.1. Subsequently, the joined microchip 20 was put into a thermostat oven at 90 °C for 2 minutes. After the above treatment, the deflection angle and the amount of deflection of the resin film 20 at the flow path groove 11 and the amount of deflection of the resin film 20 at the through-hole 15 were re-determined, and the results were as follows: the deflection angle θ = 29 °, t/d = 0.12, and T/D = 0.04, thereby it was confirmed that the deflection of the resin film 20 was reduced.

### (Test of Electrophoresis using Microchip)

First, a viscous polymer solution (polydimethylacrylamide, pDMA) was charged from the through-hole 15. Since the resin substrate 10 made of acrylic resin such as polymethyl methacrylate is hydrophilic, it was possible to introduce it through capillarity. The polymer solution was also charged into each of through-holes 15 so as to level the liquid. After that, a fluorescenfly-labeled DNA having the number of base pair of 100 bp to 1,000 bp was dropped into the through-hole 15 for injecting a sample, and then, introduction and separation were carried out by applying a direct voltage. When excitation and detection were carried out at a prescribed detection section by using a confocal laser scanning microscope, a tailing of the DNA plug (a band) at the both ends of the flow path groove 11 was observed, and as a result, portions, in which signals between each of bases were overlapped, were appeared, but the DNA plugs were detectable level. When multiple tests were conducted on a like-for-like basis, due to an effect of the resin film 20 being deflected toward the inside of the flow path groove 11, the cross section of the minute flow path was unstable, resulting in slight degradation of the reproducibility. However, it was found that the microchip was a usable level depending on the particular analyzing object.

### (Example 5)

### (Joining of Resin Substrate 10 to Resin Film 20, and Thermal Annealing)

Next, Example 5 will be described. An acrylic resin such as polymethyl methacrylate, which is a transparent resin material, (DELPET 70 NH, manufactured by Asahi Kasei Corp.) was molded using an injection molding machine, to manufacture the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin film 20, an acrylic resin such as polymethyl methacrylate, which is a transparent resin material, (SUNDUREN, 100 µm in thickness, manufactured by Kaneka Corp.), was cut into 50 mm × 50 mm. Then, the resin film 20 was placed on the joint surface 12 of the resin substrate 10 on which the flow path grooves 11 were formed, which were then pressure bonded using a heat press at press temperature of 105 °C and with a force of 10 kgf/cm², to join the resin substrate 10 to the resin film 20. After joining them, using the confocal laser scanning microscope OLS3000 manufactured by Olympus Corporation, the deflection angle and the amount of deflection of the resin film 20 at the flow path groove 11 and the amount of deflection of the resin film 20 at the through-hole 15 were determined. The results were as follows: the deflection angle θ of the resin film 20 was 35 °, the ratio of the amount of the deflection t with respect to the depth d of the flow path groove 11 (= t/d) was 0.17, and the ratio of the amount of the deflection T with respect to the depth D of the through-hole 15 (= T/D) was 0.08. Subsequently, the joined microchip 20 was put into a thermostat oven at 90 °C for one hour. After the above treatment, the deflection angle and the amount of deflection of the resin film 20 at the flow path groove 11 and the amount of deflection of the resin film 20 at the through-hole 15 were re-determined, and the results were as follows: the deflection angle θ = 8 °, t/d =0.08, and T/D = 0.03, thereby it was confirmed that the deflection of the resin film 20 was reduced.

### (Test of Electrophoresis using Microchip)

First, a viscous polymer solution (polydimethylacrylamide, pDMA) was charged from the through-hole 15. Since the resin substrate 10 made of acrylic resin such as polymethyl methacrylate is hydrophilic, it was possible to introduce it through capillarity. The polymer solution was also charged into each of through-holes 15 so as to level the liquid. After that, a fluorescently-labeled DNA having the number of base pair of 100 bp to 1,000 bp was dropped into the through-hole 15 for injecting a sample, and then, introduction and separation were carried out by applying a direct voltage. When excitation and detection were carried out at a prescribed detection section by using a confocal laser scanning microscope, the central portion of the DNA plug (band) showed a shape similar to a plug flow, even though a slight tailing of the DNA plug at the both ends of the flow path groove 11 was observed. Since the boundaries of the DNA plugs were clear, clear peaks were detected at a detection side. When multiple tests were conducted on a like-for-like basis, good reproducibility was confirmed.

### (Example 6)

### (Joining of Resin Substrate 10 to Resin Film 20, and Thermal Annealing)

Next, Example 6 will be described. An acrylic resin such as polymethyl methacrylate, which is a transparent resin material, (DELPET 70 NH, manufactured by Asahi Kasei Corp.) was molded using an injection molding machine to manufacture the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin film 20, an acrylic resin such as polymethyl methacrylate, which is a transparent resin material, (TECHNOLOY, 100 µm in thickness, manufactured by Sumitomo Chemical Co., Ltd.), was cut into 50 mm × 50 mm. Then, the resin film 20 was placed on the joint surface 12 of the resin substrate 10 on which the flow path grooves 11 were formed, which were then pressure bonded using a heat press at press temperature of 115 °C and with a force of 10 kgf/cm², to join the resin substrate 10 to the resin film 20. After joining them, using the confocal laser scanning microscope OLS3000 manufactured by Olympus Corporation, the deflection angle and the amount of deflection of the resin film 20 at the flow path groove 11, and the amount of deflection of the resin film 20 at the through-hole 15 were determined. The results were as follows: the deflection angle θ of the resin film 20 was 40 °, the ratio of the amount of the deflection t with respect to the depth d of the flow path groove 11 (= t/d) was 0.22, and the ratio of the amount of the deflection T with respect to the depth D of the through-hole 15 (=T/D) was 0.1. Subsequently, the joined microchip 20 was put into a thermostat oven at 90 °C for one hour. After the above treatment, the deflection angle and the amount of deflection of the resin film 20 at the flow path groove 11, and the amount of deflection of the resin film 20 at the through-hole 15 were re-determined, and the results were as follows: the deflection angle θ = 20 °, t/d = 0.12, and T/D = 0.03, thereby it was confirmed that the deflection was reduced.

### (Test of Electrophoresis using Microchip)

First, a viscous polymer solution (polydimethylacrylamide, pDMA) was charged from the through-hole 15. Since the resin substrate 10 made of acrylic resin such as polymethyl methacrylate is hydrophilic, it was possible to introduce it through capillarity. The polymer solution was also charged into each of through-holes 15 so as to level the liquid. After that, a fluorescently-labeled DNA having the number of base pair of 100 bp to 1,000 bp was dropped into the through-hole 15 for injecting a sample, and then, introduction and separation were carried out by applying a direct voltage. When excitation and detection were carried out at a prescribed detection section by using a confocal laser scanning microscope, the central portion of the DNA plug (a band) showed a shape similar to a plug flow, even though a slight tailing of the DNA plug at the both ends of the flow path groove 11 was observed. Since the boundaries of the DNA plugs were clear, clear peaks were detected at a detection side. When multiple tests were conducted on a like-for-like basis, due to an effect of the resin film 20 being deflected toward the inside of the flow path groove 11, the cross section of the minute flow path was unstable, resulting in slight degradation of the reproducibility. However, it was found that the microchip was a usable level depending on the particular analyzing object.

### (Example 7)

### (Joining of Resin Substrate 10 to Resin Film 20, and Thermal Annealing)

Next, Example 7 will be described. An acrylic resin such as polymethyl methacrylate, which is a transparent resin material, (DELPET 70 NH, manufactured by Asahi Kasei Corp.) was molded using an injection molding machine, to manufacture the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin film 20, an acrylic resin such as polymethyl methacrylate, which is a transparent resin material, (ACRYPLENE, 75 µm in thickness, manufactured by Mitsubishi Rayon Co., Ltd.), was cut into 50 mm × 50 mm. Then, the resin film 20 was placed on the joint surface 12 of the resin substrate 10 on which the flow path grooves 11 were formed, which were then pressure bonded using a heat press at press temperature of 90 °C and with a force of 10 kgf/cm², to join the resin substrate 10 to the resin film 20. After joining them, using the confocal laser scanning microscope OLS3000 manufactured by Olympus Corporation, the deflection angle and the amount of deflection of the resin film 20 at the flow path groove 11, and the amount of deflection of the resin film 20 at the through-hole 15 were determined. The results were as follows: the deflection angle θ of the resin film 20 was 40 °, the ratio of the amount of the deflection t with respect to the depth d of the flow path groove 11 (= t/d) was 0.2, and the ratio of the amount of the deflection T with respect to the depth D of the through-hole 15 (= T/D) was 0.1. Next, by using a heat blower to the microchip, the surface temperature of the microchip was controlled to be 90 °C, and then the microchip was heated and blown at 90 °C for one minute. The surface temperature was determined using a non-contact emission thermometer. After the above treatment, the deflection angle and the amount of deflection of the resin film 20 at the flow path groove 11, and the amount of deflection of the resin film 20 at the through-hole 15 were re-determined, and the results were as follows: the deflection angle θ = 0 °, t/d = 0, and T/D = 0, thereby it was confirmed that the deflection was entirely eliminated.

### (Test of Electrophoresis using Microchip)

First, a viscous polymer solution (polydimethylacrylamide, pDMA) was charged from the through-hole 15. Since the resin substrate 10 made of acrylic resin such as polymethyl methacrylate is hydrophilic, it was possible to introduce it through capillarity. The polymer solution was also charged into each of through-holes 15 so as to level the liquid. After that, a fluoresccntly-labeled DNA having the number of base pair of 100 bp to 1,000 bp was dropped into the through-hole 15 for injecting a sample, and then, introduction and separation were carried out by applying a direct voltage. When excitation and detection were carried out at a prescribed detection section by using a confocal laser scanning microscope, it was observed that the DNA plug (a band) was separated while forming a plug flow. Since the boundaries of the DNA plugs were clear, clear peaks were detected at a detection side. When multiple tests were conducted on a like-for-like basis, very good reproducibility was confirmed.

### (Example 8)

### (Joining of Resin Substrate 10 to Resin Film 20, and Thermal Annealing)

Next, Example 8 will be described. An acrylic resin such as polymethyl methacrylate, which is a transparent resin material, (DELPET 70 NH, manufactured by Asahi Kasei Corp.) was molded using an injection molding machine, to manufacture the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin film 20, an acrylic resin such as polymethyl methacrylate, which is a transparent resin material, (ACRYPLENE, 75 µm in thickness, manufactured by Mitsubishi Rayon Co., Ltd.), was cut into 50 mm × 50 mm. Then, the resin film 20 was placed on the joint surface 12 of the resin substrate 10 on which the flow path grooves 11 were formed, which were then pressure bonded using a heat press at press temperature of 90 °C and with a force of 10 kgf/cm², to join the resin substrate 10 to the resin film 20. After joining them, using the confocal laser scanning microscope OLS3000 manufactured by Olympus Corporation, the deflection angle and the amount of deflection of the resin film 20 at the flow path groove 11, and the amount of deflection of the resin film 20 at the through-hole 15 were determined. The results were as follows: the deflection angle θ of the resin film 20 was 40 °, the ratio of the amount of the deflection t with respect to the depth d of the flow path groove 11 (= t/d) was 0.2, and the ratio of the amount of the deflection T with respect to the depth D of the through-hole 15 (= T/D) was 0.1. Next, by using an ultraviolet light irradiation device, irradiation was carried out for 30 seconds from the resin film 20 side at an irradiation density of 500 mW/cm² (the measuring wavelength λ = 365 nm). The surface temperature was 90 °C when measured with a non-contact emission thermometer. After the above treatment, the deflection angle and the amount of deflection of the resin film 20 at the flow path groove 11, and the amount of deflection of the resin film 20 at the through-hole 15 were re-determined, and the results were as follows: the deflection angle θ = 0 °, t/d = 0, and T/D = 0, thereby it was confirmed that the deflection was entirely eliminated.

### (Test of Electrophoresis using Microchip)

First, a viscous polymer solution (polydimethylacrylamide, pDMA) was charged from the through-hole 15. Since acrylic resin such as polymethyl methacrylate is hydrophilic, it was possible to introduce it through capillarity. The polymer solution was also charged into each of through-holes 15 so as to level the liquid. After that, a fluorescently-labeled DNA having the number of base pair of 100 bp to 1,000 bp was dropped into the through-hole 15 for injecting a sample, and then, introduction and separation were carried out by applying a direct voltage. When excitation and detection were carried out at a prescribed detection section by using a confocal laser scanning microscope, it was observed that the DNA plug (a band) was separated while forming a plug flow. Since the boundaries of the DNA plugs were clear, clear peaks were detected at a detection side. When multiple tests were conducted on a like-for-like basis, very good reproducibility was confirmed.

The materials for the microchip and the manufacturing methods thereof as shown in Examples 1 to 8 are just an example, and this invention is not limited to them.

Subsequently, comparative examples will be described. The following comparative examples are an example in which the microchip is not subjected to annealing after the resin substrate 10 is joined to the resin film 20. In the comparative examples, the description that overlaps with each other will be omitted.

### (Comparative Example 1)

Next, Comparative Example 1 will be described. An acrylic resin such as polymethyl methacrylate, which is a transparent resin material, (DELPET 70 NH, manufactured by Asahi Kasei Corp.) was molded using an injection molding machine, to manufacture the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin film 20, an acrylic resin such as polymethyl methacrylate, which is a transparent resin material, (ACRYPLENE, 75 µm in thickness, manufactured by Mitsubishi Rayon Co., Ltd.), was cut into 50 mm × 50 mm. Then, the resin film 20 was placed on the joint surface 12 of the resin substrate 10 on which the flow path grooves 11 were formed, which were then pressure bonded using a heat press at press temperature of 90 °C and with a force of 10 kgf/cm², to join the resin substrate 10 to the resin film 20. After joining them, using the confocal laser scanning microscope OLS3000 manufactured by Olympus Corporation, the deflection angle and the amount of deflection of the resin film 20 at the flow path groove 11, and the amount of deflection of the resin film 20 at the through-hole 15 were determined. The results were as follows: the deflection angle θ of the resin film 20 was 40 °, the ratio of the amount of the deflection t with respect to the depth d of the flow path groove 11 (= t/d) was 0.2, and the ratio of the amount of the deflection T with respect to the depth D of the through-hole 15 (= T/D) was 0.1.

### (Test of Electrophoresis using Microchip)

First, a viscous polymer solution (polydimethylacrylamide, pDMA) was charged from the through-hole 15. Since the resin substrate 10 made of acrylic resin such as polymethyl methacrylate is hydrophilic, it was possible to introduce it through capillarity. The polymer solution was also charged into each of through-holes 15 so as to level the liquid. After that, a fluoreseendy-labeled DNA having the number of base pair of 100 bp to 1,000 bp was dropped into the through-hole 15 for injecting a sample, and then, introduction and separation were carried out by applying a direct voltage. When excitation and detection were carried out at a prescribed detection section by using a confocal laser scanning microscope, a tailing of the DNA plug (a band) at the both ends of the flow path groove 11 was observed, and the DNA plug showed a crescent-like shape. In addition to that, the minute flow path formed a pseudo concavo-plane cylindrical lens, thereby the excited detection light diverged. As a result, the detection peak became weak and the shape of it was broadened, thereby DNA was not clearly detected. When multiple tests were conducted on a like-for-like basis, due to an effect of the deflection of the resin film 20 at the through-hole 15 (a dent of the minute flow path), the cross section of the minute flow path was unstable, and further, due to differences of the amount of deflection among the resin films 20 at through-holes, the introduced amount of polymer solution varied, resulting in no good reproducibility.

### (Comparative Example 2)

Next, Comparative Example 2 will be described. An acrylic resin such as polymethyl methacrylate, which is a transparent resin material, (DELPET 70 NH, manufactured by Asahi Kasei Corp.) was molded using an injection molding machine to manufacture the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin film 20, an acrylic resin such as polymethyl methacrylate, which is a transparent resin material, (SUNDUREN, 100 µm in thickness, manufactured by Kaneka Corp.), was cut into 50 mm × 50 mm. Then, the resin film 20 was placed on the joint surface 12 of the resin substrate 10 on which the flow path grooves 11 were formed, which were then pressure bonded using a heat press at press temperature of 105 °C and with a force of 10 kgf/cm², to join the resin substrate 10 to the resin film 20. After joining them, using the confocal laser scanning microscope OLS3000 manufactured by Olympus Corporation, the deflection angle and the amount of deflection of the resin film 20 at the flow path groove 11, and the amount of deflection of the resin film 20 at the through-hole 15 were determined. The results were as follows: the deflection angle θ of the resin film 20 was 35 °, the ratio of the amount of the deflection t with respect to the depth d of the flow path groove 11 (= t/d) was 0.17, and the ratio of the amount of the deflection T with respect to the depth D of the through-hole 15 (= T/D) was 0.08.

### (Test of Electrophoresis using Microchip)

Since the method of this electrophoresis test and its results were similar to those of Comparative Example 1, descriptions thereof are omitted.

### (Comparative Example 3)

Next, Comparative Example 3 will be described. PMMA resin, which is a transparent resin material, (DELPET 70 NH, manufactured by Asahi Kasei Corp.) was molded using an injection molding machine, to manufacture the resin substrate 10, which was constituted of the plural flow path grooves 11 of 50 µm in width and 50 µm in depth and the plural through-holes of 2 mm in internal diameter, on a plate-like member of 50 mm × 50 mm × 1 mm in external dimensions.

As the resin film 20, an acrylic resin such as polymethyl methacrylate, which is a transparent resin material, (TECHNOLOY, 100 µm in thickness, manufactured by Sumitomo Chemical Co., Ltd.), was cut into 50 mm × 50 mm. Then, the resin film 20 was placed on the joint surface 12 of the resin substrate 10 on which the flow path grooves 11 were formed, which were then pressure bonded using a heat press at press temperature of 115°C and with a force of 10 kgf/cm², to join the resin substrate 10 to the resin film 20. After joining them, using the confocal laser scanning microscope OLS3000 manufactured by Olympus Corporation, the deflection angle and the amount of deflection of the resin film 20 at the flow path groove 11 and the amount of deflection of the resin film 20 at the through-hole 15 were determined. The results were as follows: the deflection angle θ of the resin film 20 was 30°, the ratio of the amount of the deflection t with respect to the depth d of the flow path groove 11 (= t/d) was 0.15, and the ratio of the amount of the deflection T with respect to the depth D of the through-hole 15 (= T/D) was 0.05.

### (Test of Electrophoresis using Microchip)

Since the method of this electrophoresis test and its results were similar to those of Comparative Example 1, descriptions thereof are omitted.

As mentioned above, the examples and the comparative examples were described. In the examples, when the thermal annealing is carried out after the resin film 20 is joined to the resin substrate 10, the deflection of the resin film is reduced or entirely eliminated. As a result, an excellent reproducibility was confirmed in the electrophoresis test using the microchip. Further, it was found that some microchips were at a usable level depending on the analyzing object. On the other hand, in comparative examples, it was found that, when the thermal annealing was not carried out after the resin film 20 was joined to the resin substrate 10, an excellent reproducibility was unable to obtain in the electrophoresis test using the microchip caused by the deflection of the resin film.

## Claims

1. A microchip which is composed of a resin substrate on which a flow path groove is formed, and has a flow path formed by joining a resin film to a surface of the substrate on which the flow path groove is formed,
wherein, at each position of the flow path, a deflection angle of the resin film in a cross section in a width direction of the flow path is 0° or more and less than 30°.

2. The microchip described in Claim 1, wherein the deflection angle of the above resin film is 0° or more and less than 10°.

3. The microchip described in Claims 1 or 2, wherein at each position of the flow path, a value of ratio of a deflection quantity of the resin film at the sectional surface in the width direction of the flow path to a depth of the flow path is 0 or more and less than 0.1.

4. The microchip described in Claim 3, wherein the value of ratio of the deflection quantity of the resin film to the depth of the flow path groove is 0 or more and less than 0.05.

5. The microchip described in any one of Claims 1 to 4 in which a through-hole connected to the flow path groove is further formed on the resin substrate,
wherein the resin film is disposed so as to cover the through-hole, and
the value of ratio of the deflection quantity of the resin film to a depth of the through-hole at a sectional surface in a longitudinal direction through a maximum diameter of the through-hole is 0 or more and less than 0.05.

6. The microchip described in Claim 5, wherein the value of the deflection quantity of the resin film with respect to the depth of the through-hole at the sectional surface in the longitudinal direction through the maximum diameter of the through-hole is 0 or more and less than 0.01.

7. A method for manufacturing a microchip, comprising steps of:
forming a flow path by joining, via a thermal fusion deposition, a resin film to a surface of a resin substrate on which a flow path groove is formed; and
making a deflection angle of the resin film in a width direction of the flow path to be 0° or more and less than 30° at each position of the flow path by conducting thermal annealing at a prescribed temperature of the resin substrate and the resin film, both of which were subjected to the joining.

8. The method for manufacturing the microchip described in Claim 7, wherein a through-hole connected to the flow path groove is formed on the resin substrate, and the resin film is joined to the resin substrate so as to cover the through-hole, and the value of ratio of the deflection quantity of the resin film to a depth of the through-hole at the sectional surface in the longitudinal direction through the maximum diameter of the through-hole is made to be 0 or more and less than 0.05 by the above thermal annealing step.

9. The method for manufacturing the microchip described in Claim 8, wherein, in the joining of the resin film to the surface of the resin substrate on which the flow path groove was formed, the resin film is supported by inserting a pin in such a way that the tip of the pin is located at a position of almost the same as a height of an edge of hole of the through-hole.
